Europäisches Patentamt

(19) European Patent Office

Office européen des brevets

(11) Publication number: **0 140 791**
A1

## (12) EUROPEAN PATENT APPLICATION

(21) Application number: **84402155.0**

(22) Date of filing: **26.10.84**

(51) Int. Cl.⁴: **C 23 C 16/44, C 30 B 25/14**

(30) Priority: **28.10.83 US 546737**

(43) Date of publication of application: **08.05.85**
**Bulletin 85/19**

(84) Designated Contracting States: **CH DE FR GB LI NL SE**

(71) Applicant: **B T U Engineering Corporation, Esquire Road, No. Billerica Massachusetts 01862 (US)**

(72) Inventor: **Sarkozy, Robert F., 85 Concord Road, Westford Massachusetts 01886 (US)**
Inventor: **Epps, Kenneth C., 24 Avon Place, Arlington Massachusetts 02174 (US)**

(74) Representative: **Descourtieux, Philippe et al, CABINET BEAU de LOMENIE 55 rue d'Amsterdam, F-75008 Paris (FR)**

(54) Apparatus for providing uniform thickness CVD thin-film on semiconductor substrates.

(57) Apparatus for providing uniform thickness CVD thinfilm on semiconductor substrates includes a diffusion tube defining a reaction chamber maintained at a controlled temperature and pressure, reactant gas injection tubes positioned in the diffusion tube for introducing reactant gas in a gas injection region that longitudinally extends along the reaction chamber, and a monolithic gas diffuser (62) positioned adjacent the gas injection region. The gas diffuser has open ends and a longitudinally extending opening (66) dimensioned to accept a wafer-loaded boat. The gas diffuser circulates the reactant gas uniformly into contact with the entire planar surfaces of each of the wafers for providing a CVD thinfilm thereon of uniform thickness. The monolithic gas diffuser includes a bottom wall (70) having a plurality of longitudinally spaced apertures (68) defining percolation vias, and opposed side walls (72, 74) integrally formed with the bottom wall having edges (75, 77) defining the longitudinally extending opening (66). The reactant gas passes through the percolation vias into contact with the wafers, and the opposed side walls direct the reactant gas in laminar flows peripheral to the sidewalls and toward the longitudinally extending opening. The edges convert the laminar flow into turbulent flow that creates aerodynamic vortices (94, 96) that direct the reactant gas into uniform contact with the region of the wafers remote from the percolation vias.

FIELD OF THE INVENTION

This invention is directed to the field of integrated circuit fabrication, and more particularly to a novel apparatus for providing uniform thickness CVD thin-film on semiconductor substrates.

BACKGROUND OF THE INVENTION

Thin-films of selected materials are formed on semiconductor wafers during the various phases of integrated circuit fabrication processes. Such films are produced during the initial processes run on the starting material, during the imaging processes that replicate various integrated circuit pattern geometries, during deposition and growth processes for producing intended electrical characteristics, and during mask-forming processes, among others.

The semiconductor wafers are typically loaded onto a boat with the plane of each of the wafers parallel with each other and coincident with the vertical plane, and batch-processed in the cylindrical bore of a CVD diffusion furnace having a selected process temperature and pressure. Reactants in gas phase for the selected CVD process that is being run on the particular batch of wafers are injected in the furnace, and react and deposit a selected thin-film in solid phase on the surfaces of the semiconductor wafers. Any number of thin-films can be successively formed by the appropriate selection of reactants, temperature, and pressure during the various CVD processing steps employed during integrated circuit fabrication.

In many CVD thin-film formation processes, such as the so-called low temperature oxide (LTO) processes, the gases react so quickly as to produce an undesirable nonuniformity in the thickness of the deposited thin-film, not only between the wafers of a batch, but also in the individual wafers themselves. One known technique to provide a uniform thickness thin-film on the wafers of a batch uses a gas injection system having a plurality of apertured gas injection tubes so spaced along the length of the boat that the same amount of reactant is locally introduced adjacent each of the substrates. However, this type of gas injection system is costly to manufacture, replace, and repair, and still produces a variation between the wafers of a batch even when 5-10 separate apertured gas injection tubes are employed. It moreover often results in an uneven thickness dimension on individual ones of the wafers.

Another known technique employed to promote the uniform deposition of thin-film on semiconductor substrates during CVD deposition processes employs a two-part matable structure that forms a cage for the boat as disclosed in U.S. Patent No. 4,309,240 to Zaferes. Each part consists of a plurality of parallel, elongated cylindrical rods that are fastened at their ends in spaced-apart relation to semicircular end rails defining a semicylindrical surface having longitudinally extending slots formed between adjacent ones of the cylindrical rods. Gas injected below the cage is intercepted by the lower cylindrical rods, which create aerodynamic vortices that direct the gas onto the bottom surface of the semiconductor wafers. The cylindrical rods of the upper half of the cage intercept the gas flow, and likewise create aerodynamic vortices that direct the gas back through the slots onto the top surfaces of the wafers. However, this cage structure is extremely expensive to fabricate since it requires multiple tack welds between the ends of the cylindrical rods and the supporting semicircular end rails. Moreover, due to its intricate design, cage breakage often occurs during cleaning to remove deposit buildup and during routine handling. In addition, the difference in thermal expansion between the deposited material and the material of the cage introduces thermal stress on the tack welds that may result in the breaking of the cage, requiring its replacement and possibly contaminating the particular batch of substrates.

It is also known to provide a two-part cylindrical cage having two semicylindrical mating shell portions, where each shell portion has a slot pattern cut therein- to by a laser beam. With this structure, aerodynamic vortices are created as the reacting gases pass through the very fine laser-cut slots provided peripherally around the surface of the cylinder and into contact with the wafers. However, such two-part cage structures require removal of the top shell portion during boat loading and removal, and the laser cutting of the fine slots into an intended pattern considerably increases the cost of the apertured cylindrical cage, among other disadvantages.

SUMMARY OF THE INVENTION

The novel apparatus for providing uniform thickness thin-film on semiconductor substrates of the present invention contemplates a diffusion furnace having a horizontally extending furnace tube defining a reaction chamber, means for controllably heating the reaction chamber, means for controllably evacuating the reaction chamber, means for loading a boat having semiconductor wafers to be processed into the reaction chamber and for unloading the wafers from the reaction chamber after CVD processing, means for controllably injecting reactant in gas phase uniformly into the reaction chamber along a region locally adjacent the wafers, and a gas diffuser of monolithic construction intermediate the gas injection region and the wafers. The gas diffuser of monolithic construction has open ends, and a longitudinally extending opening of dimensions selected to allow the ready loading and unloading of conventional semiconductor boats therethrough before and after CVD processing. The monolithic gas diffuser has a bottom wall opposite the longitudinally extending opening having apertures defining percolation vias through which a portion of the reactant in gas phase passes into communication with the adjacent surfaces of the semiconductor wafers, and has opposed solid side walls integrally formed with the bottom wall that laterally extend along the length of the reaction chamber. The opposed side walls direct the remaining portion of the reactant in gas phase in laminar flows laterally around the integral opposed side walls and toward the longitudinally extending opening thereof. At the boundary defined at the edge of the corresponding opposed sidewalls, each laminar flow is converted into a turbulent flow that creates aerodynamic vortices that swirl the reactant in gas phase uniformly into the region of the wafers remote from the percolation vias. The monolithic diffuser is of quartz and preferably of cylindrical shape, and has an opening that preferably subtends 130 degrees. The apertures defining the percolation vias preferably are produced by conventional drilling techniques, and preferably extend in two parallel rows longitudinally along the diffuser. The wafers in this manner can be batch processed in a conventional boat which is inserted through the longitudinal opening and is supported on the inside surface of the monolithic diffuser. First and second apertures are provided proximate the ends of the monolithic diffuser on one of the opposed side walls that are adapted to receive a yoked pick-up tool for the expeditious removal of the diffuser, and for its placement on the boat loader, in a matter of seconds. The diffuser may rapidly be chemically etched to remove deposits after use without fear of breaking. Due to the absence of tack welds and the like, differential thermal expansion induced breakage is substantially eliminated.

BRIEF DESCRIPTION OF THE DRAWINGS.

These and other features and advantages of the present invention will become apparent as the invention becomes better understood by referring to the following exemplary and non-limiting detailed description of the preferred embodiment, and to the drawings, wherein :

Fig. 1 is a not-to-scale pictorial diagram illustrating a chemical vapor deposition (CVD) apparatus for forming uniform thickness thin-film on semiconductor substrates according to the present invention;

Fig. 2 is a not-to-scale perspective view illustrating the monolithic gas diffuser of the CVD apparatus for forming uniform thickness thin-film on semiconductor substrates according to the present invention; and

Fig. 3 is a schematic sectional diagram illustrating the CVD apparatus for forming uniform thickness thin-film on semiconductor substrates according to the present invention.

DETAILED DESCRIPTION OF THE PREFERRED EMBODIMENT

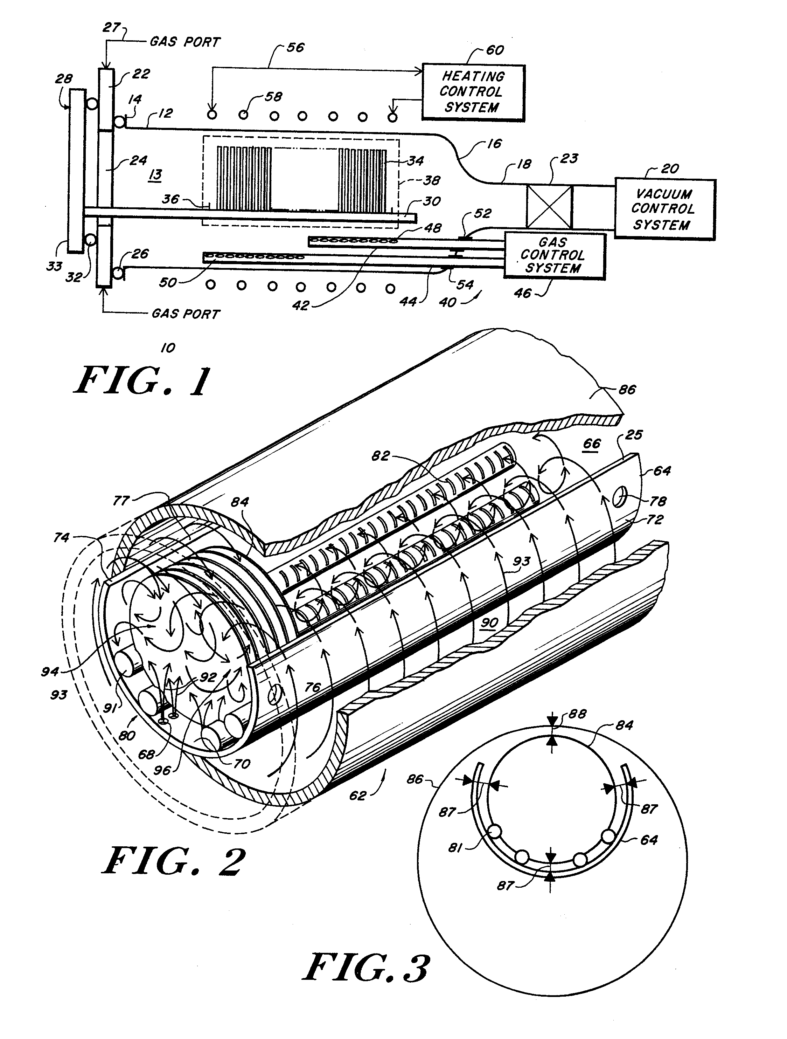

Referring now to Fig. 1, generally designated at 10 is a novel chemical vapor deposition (CVD) apparatus for forming uniform thickness thin-film on semiconductor substrates according to the present invention. The apparatus 10 includes a cylindrical diffusion tube 12, fashioned from any suitable high-temperature resistant material such as quartz, defining a horizontally extending reaction chamber 13. An integral flange 14 is provided on one end of the diffusion tube 12. A neck 16 that tapers to a throat 18 is provided on the other end of the diffusion tube 12. A vacuum control system 20 is connected to the throat 18 via a ball valve joint 22 for controllably evacuating the reaction chamber 13.

A plate 22 having a central bore 24 is removably fastened to the annular flange 14 of the diffusion tube 12 over an O-ring 26 in air-tight sealing engagement therewith. The plate has gas ports 27 in communication with the reaction chamber. A boat loading mechanism generally designated 28 having a horizontally extending cantilevered arm 30 is provided for inserting boats having a plurality of semiconductor substrates through the aperture 24 of the plate 22 into the chamber 13 of the diffusion tube 12 for processing, and for removing the semiconductor substrates after processing. The boat loader 28 includes a door 33 connected to a suitable actuator, not shown, for controlling its translation. An O-ring 32 is provided between the door 33 and the plate 22 for providing an air-tight seal therebetween.

A plurality of planar semiconductor wafers 34 are supported by a boat 36 in spaced relation longitudinally along the length of the diffusion tube 12, with the planar surface of each of the wafers generally coincident with the vertical plane. A gas diffuser designated by a dashed box 38 to be described is provided intermediate the wafers 34 and the arm 30. As appears more fully below, the boat 38 is supported by the gas diffuser 38, and may readily be inserted and removed therefrom through an opening provided therein to be described.

A gas injection system generally designated 40 is provided for controllably injecting one or more reactants in gas phase into the reaction chamber 13 defined by the cylindrical diffusion tube 12. The gas control system 40 preferably includes first and second elongated, cylindrical injection tubes 42, 44 connected on one end to a gas control system 46 and terminating on their other ends in a plurality of gas injection apertures 48, 50. Seals 52, 54 are provided for sealing the tubes 42, 44 in air-tight sealing engagement with the confronting surface of the tapering wall of the neck 16 of the tube 12.

A heating system generally designated 56 is provided for controllably establishing the temperature inside the reaction chamber 13. The heating control system in the illustrated embodiment includes heating coils 58 that are wrapped peripherally around the exterior of the diffusion tube 12 and electrically connected to a heating control system 60. By controlling the current and voltage applied to the coils, and by sensing the internal temperature in the interior of the diffusion tube, the control system 60 establishes and maintains any desired temperature for a particular CVD process.

By way of example and not by way of limitation, the apparatus 10 can advantageously be employed to batch process semiconductor wafers using the so-called low-temperature oxide chemical vapor deposition process. For this reaction, the vacuum control system is operative to maintain the pressure in the diffusion tube 12 at about substantially 500 microns, the gas control system 46 is operative to inject silane ($SiH_4$) into the region of the diffusion tube 12 subjacent the plurality of wafers 34 locally uniformly therealong, the gas ports 27 are operative to inject an excess amount of oxygen ($O_2$) into the volume of the reaction chamber, and the heating control system 60 is operative to produce a uniform temperature in the reaction chamber of substantially 425°C. As appears more fully below, the gas diffuser 38 directs the reactant in gas phase into uniform contact over the entire planar surface of the wafers 34, where the reactant gas deposits a uniform thickness thin-film on the planar surfaces of each of the wafers.

Referring now to Fig. 2, generally designated at 62 is a perspective view of the monolithic gas diffuser of the chemical vapor deposition apparatus for depositing uniform thickness thin-film on semiconductor substrates according to the present invention. The diffuser 62 preferably includes a monolithic quartz cylinder 64 having open ends, and having a longitudinally extending opening generally designated 66 that subtends a preselected angle θ selected to provide an opening through which the insertion and removal of boat-loaded semiconductor wafers can expeditiously be accomplished. Preferably, the angle θ is selected to be 130 degrees.

A plurality of spaced apertures 68 defining percolation vias are provided longitudinally along a wall 70 of the cylindrical diffuser 64 that is remote from the opening 66. The percolation vias 68 preferably have a center-to-center spacing of one inch, and a diameter on the order of one-eighth inch. The percolation vias may be readily hand-drilled, preferably in one or two longitudinally extending rows, along the length of the wall 70 of the diffuser 64.

The monolithic cylindrical diffuser 84 has longitudinally extending opposed side walls 72, 74 that terminate in longitudinally extending parallel edges 75, 77 defined at the boundary with the longitudinally extending opening 66. The wall 72 is provided with first and second apertures 76, 78 each proximate a respective open end and remote from the opening 66. The apertures 76, 78 are cooperative with a yoked lifting tool, not shown, for removal and placement of the diffuser 64 on the arm 30 (Fig. 1).

A conventional boat generally designated 80 having rails 81 is inserted through the opening 66, and is supported on the confronting wall of the monolithic cylindrical gas diffuser 64. Each rail has a plurality of longitudinally spaced transverse slots 82. A plurality of planar semiconductor wafers 84 are removably supported in selected slots 82, with the planar surfaces of each of the wafers being generally coincident with the vertical plane and spaced apart along the length of the gas diffuser 64. As can best be seen in Fig. 3, the gas diffuser 64 is preferably inserted in a cylindrical diffusion tube 86 such that the radial distance 87 defined between the periphery of each of the wafers and the confronting surface of the monolithic diffuser 64 equals the radial distance 88 defined between the peripheral surface of each of the wafers and the confronting wall of the diffusion tube.

In operation, the tubes 48, 50 (Fig. 1) inject reactant in gas phase into a region generally designated 90 locally uniformly subjacent the percolation vias 68. A portion of the reactant in gas phase passes through the vias 68 into the interior of the monolithic gas diffuser 64 and onto the adjacent surfaces of each of the semiconductor wafers 76 as illustrated by the arrows 92. The laterally extending side walls 72, 74 of the monolithic gas diffuser 64 direct the remaining portion of the reactant in gas phase illustrated by the arrows 91, 93 in laminar flows laterally to the sides of the diffuser 64 and peripherally upwardly towards the opening 66. At the boundaries defined by the edges 75, 77, the laminar flow of the reactant in gas phase is converted into turbulent flow creating aerodynamic vortices illustrated at 94, 96 that uniformly direct the reactant in gas phase into contact with the region of the wafers remote from the percolation vias 68. Due to the equidistant spacing of the wafers from its confronting surfaces and as a result of the uniform flow distribution produced by the gas diffuser 64, it has been found that thin-film deposits are formed on the corresponding wafers having uniform intrawafer and interwafer thicknesses. By adjusting such parameters as the inside and outside dimensions of the monolithic gas diffuser 64, and the sizes of the percolation vias 68, their number, and relative spacing, the diffuser 64 can be employed for variable size wafers in any one of a plurality of chemical vapor deposition processes known to those skilled in the art.

It will be appreciated that many modifications of the presently disclosed invention will become apparent to those skilled in the art without departing from the scope of the appended claims.

## CLAIMS

1. A chemical vapor deposition apparatus for providing uniform thickness thin-film on a plurality of semiconductor substrates, comprising :

a diffusion tube (12) defining a reaction chamber (13);

means (56) coupled to said diffusion tube for controllably providing a selected temperature in said reaction chamber;

means (20) coupled to said diffusion tube for providing an intended pressure in said reaction chamber;

means (40) coupled to said diffusion tube for locally injecting reactant gas uniformly into a longitudinally extending region of said reaction chamber; and

means (28) for loading said plurality of semiconductor substrates into said chamber and for removing the substrates from said chamber;

characterized by :

a monolithic gas diffuser (62) positioned in said reaction chamber (13) adjacent said longitudinally extending region and partially surrounding said plurality of substrates (34), said monolithic gas diffuser having a first wall (70) having openings (68) defining percolation vias through which said reactant gas is directed from said region uniformly into contact with the adjacent surfaces of each of said plurality of wafers , said monolithic gas diffuser having second and third opposed solid walls (72,74) integrally formed with said first wall that terminate in edges (75,77) remote from said first wall defining a longitudinally extending opening (66), said second and third walls being operative to direct said reactant gas from said longitudinally extending region to said longitudinally extending opening in laminar flow peripherally and longitudinally along the second and third walls, said edges defining said opening being operative to convert the laminar flow of the reactant gas into turbulent flow creating aerodynamic vortices (94,96) that direct the reactant gas into uniform contact with the region of the surfaces of said plurality of semiconductor wafers remote from the region adjacent the percolation vias.

2. An apparatus according to claim 1, characterized in that said heating means (56) includes electrical coils (58).

3. An apparatus according to any one of claims 1 and 2, characterized in that said reactant injection means includes at least one injection tube (42,44) having a plurality of openings (48,50) from which the reactant gas flows.

4. An apparatus according to any one of claims 1 to 3, characterized in that said monolithic gas diffuser includes a cylinder of quartz (64) having a longitudinally extending opening (62) that subtends a preselected angle selected to allow the ready insertion and removal of the semiconductor substrates into and out of the gas diffuser.

5. An apparatus according to claim 4, characterized in that said monolithic cylindrical diffuser has open ends, and wherein one of said second and third walls (72, 74) further includes first and second apertures (76,78) proximate the ends thereof and spaced from said opening (66).

6. An apparatus according to claim 4, characterized in that the radial distance (87) between the peripheral surface of each of said wafers and the confronting surface of said cylindrical gas diffuser (64) is equal to the radial distance (88) between the peripheral surface of said wafers and the confronting wall of said diffusion tube.

7.    An apparatus according to any one of claims 1  to 6, characterized in that said diffusion tube (12) is cylindrical.

8.    An apparatus according to any one of claims 1 to 7, characterized in that said percolation vias (68) are hand-drilled apertures.

9.    An apparatus according to any one of claims 1 to 8, characterized in that said percolation vias (68) are spaced in at least one row longitudinally extending along said first wall (70).

10.    An apparatus according to any one of claims 1 to 9, characterized in that said longitudinally extending opening (66) has dimensions selected to allow the insertion and removal therethrough of semiconductor loaded boats.

11.    Apparatus for use in a CVD diffusion furnace for directing reactant in gas phase uniformly into contact with the entire planar area of a plurality of semiconductor substrates for fabricating intended thin-film structures thereon having uniform thickness, characterized by :

    a first longitudinally extending wall (70) having spaced apertures (68) defining percolation vias through which a portion of the reactant can pass; and

    second and third longtitudinally extending opposed walls (72,74) integrally formed with said first wall, said second and third walls each defining a solid baffle around which the remaining portion of the reactant can be diverted into first and second laminar flows, said second and third walls having first and second spaced edges (75,77) defining a longi-tudinally extending opening (66)ʻ remote from said vias through which the plurality of semiconductor wafers  can be inserted and removed, said first and second edges define boundaries at which said laminar flows can be converted into turbulent flows that create aerodynamic vortices (94,96) that direct the reactant into uniform contact with the plurality of semiconductor wafers.

12. An apparatus according to claim 11, characterized in that it includes a monolithic quartz cylinder (64) having open ends.

13. An apparatus according to any one of claims 11 and 12, characterized in that said longitudinally extending opening (66) subtends 130 degrees.

14. An apparatus according to claim 13, characterized in that it further includes first and second apertures (76,78) respectively provided proximate the open ends of said monolithic cylinder adapted to accept a yoked lifting tool.

0140791

FIG. 1

FIG. 2

FIG.3

0140791

European Patent
Office

**EUROPEAN SEARCH REPORT**

. Application number

EP 84 40 2155

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 056 326 (NORTHERN TELECOM) <br> * Figure 6 * | 1,3,4 | C 23 C 16/44 <br> C 30 B 25/14 |
| A | WO-A-8 103 348 (ADVANCED CRYSTAL SCIENCES) <br> * Page 9, paragraph 1 * & US-A-4 309 240 (Cat. A,D) | 1-3,7 | |
| A | US-A-4 220 116 (BURROUGHS CORP.) <br> * Column 3, lines 40-58; column 4, line 57 - column 5, line 9 * | 1,3 | |
| A | IBM TECHNICAL DISCLOSURE BULLETIN vol. 16, no. 4, September 1973, New York, USA; S. ZIRINSKY "Retort for pyrolytic vapor depositionof thin films", pages 1220-1221 <br> * Page 1220, paragraph 3 * | | **TECHNICAL FIELDS SEARCHED (Int. Cl.4)** <br><br> C 23 C 16/44 <br> C 30 B 25/12 <br> C 30 B 25/14 <br> C 30 B 35/00 |

The present search report has been drawn up for all claims

| Place of search | Date of completion of the search | Examiner |
|---|---|---|
| BERLIN | 09-01-1985 | GIBBS C.S. |